(19)

Europäisches
Patentamt
European
Patent Office
Office européen
des brevets

(11) **EP 2 860 565 A1**

(12) **EUROPEAN PATENT APPLICATION**

(43) Date of publication:
15.04.2015 Bulletin 2015/16

(21) Application number: 14160437.1

(22) Date of filing: 18.03.2014

(51) Int Cl.:
*G02B 13/00* [(2006.01)]    *G02B 13/18* [(2006.01)]
*G02B 3/04* [(2006.01)]    *G02B 9/60* [(2006.01)]

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **08.10.2013 TW 102136420**

(71) Applicant: **ABILITY OPTO-ELECTRONICS
TECHNOLOGY CO. LTD.
Taichung County 428 (TW)**

(72) Inventor: **Yu, Hung-Kuo
Taichung City 414 (TW)**

(74) Representative: **advotec.
Patent- und Rechtsanwälte
Beethovenstrasse 5
97080 Würzburg (DE)**

(54) **Optical lens for capturing image and image capture module**

(57)    The invention discloses an optical lens for capturing image and an image capture module. In order from an object side to an image side, the optical lens along the optical axis comprises a first lens element with positive refractive power having a convex object-side surface; a second lens element with positive refractive power having a convex image-side surface; a third lens element with negative refractive power having a convex image-side surface and a concave object-side surface; a fourth lens element with refractive power having a convex object-side surface, both the object-side surface and the image-side surface of the fourth lens element are aspheric; a fifth lens element with refractive power having a concave image-side surface, and at least one of the image-side surface and object-side surface has at least one inflection point. The optical lens can reduce the sensitivity for use in compact cameras with camera functionalities.

EP 2 860 565 A1

**Description**

**CROSS-REFERENCE TO RELATED APPLICATION**

This application claims priority from Taiwan Patent Application No. 102136420, filed on October 8, 2013 in Taiwan Intellectual Property Office, the contents of which are hereby incorporated by reference in their entirety.

**BACKGROUND OF THE INVENTION**

**1. Field of the Invention**

The present invention is related to an optical lens for capturing image and an image capture module using the optical lens. More particularly, the present invention relates to an optical lens having five lens elements and image capture module using the optical lens, so as to capture high resolution image and to be applied to 3C products.

**2. Description of the Related Art**

In compact electronic products such as digital cameras, mobile phone, or a panel computer, an optical lens is generally installed for capturing images of an obj ect, and the optical lens for capturing image tends to be developed with a compact design and a low cost, while meeting the user requirements of good aberration correction ability, high resolution, and high image quality.

In prior arts, an optical lens for capturing image of a compact electronic product comes with different designs, including the two-lens, three-lens, four-lens, and five-or-more lens designs. However, if the imaging quality is taken into consideration, the optical lens for capturing image with the four-lens or five-lens designs has advantages on image aberration and modulation transfer function (MTF) performance, wherein the four-lens design having a lower resolution than the five-lens. So, the five-lens design is applicable for electronic products requiring the high quality and high pixels.

In various compact designs of the five-lens optical lens for capturing image having a fixed focal length, different combinations of lens of positive and negative refractive powers are applied. For example, the fourth lens element with negative refractive power and the fifth lens element with negative refractive power are adopted to increase the back focal length and the total length of the optical lens, so that it is difficult to shorten the total length of the optical lens.

In various five-lens designs of the optical lens for capturing image with a fixed focal length, the first lens element has a convex image-side surface to facilitate a good balance between an increase of the view angle of the optical imaging system and the effect of the aberration correction, or the fourth lens element and the fifth lens element with different refractive powers are adopted, and the fourth lens element or the fifth lens element has an inflection point, and such optical lens for capturing image meets the requirements for a good aberration and a reduced total length of the optical imaging system.

Therefore, how to shorten effectively the total length of the optical lens for capturing image and improve the image quality becomes an important issue.

SUMMARY OF THE INVENTION

According to the above problem, the purpose of the present invention is to provide an optical lens for capturing image and an image capture module to shorten the total length of the optical lens and improve the image quality by the combination of five lens of refractive powers, a convex surface design, and a concave surface design. Thus, the optical lens for capturing image and the image capture module can be applied to compact electronic products.

Based on the purpose of the present invention, an optical lens for capturing image is proposed. The invention provides the optical lens, in order from an object side to an image side along the optical axis, comprising: a first lens element along the optical axis with positive refractive power having a convex object-side surface; a second lens element along the optical axis with positive refractive power having a convex image-side surface; a third lens element along the optical axis with negative refractive power having a concave object-side surface and a convex image-side surface, wherein at least one of the object-side surface and the image-side surface of the third lens element is aspheric; a fourth lens element along the optical axis with refractive power having a convex object-side surface, both the object-side surface and the image-side surface of the fourth lens element are aspheric; and a fifth lens element along the optical axis with refractive power having a concave image-side surface and both the image-side surface and the object-side surface of the fifth lens element are aspheric, and at least one of the image-side surface and the object-side surface of the fifth lens element has at least one inflection point.

Preferably, the material of the first lens element, the second lens element, the third lens element, the fourth lens element, and the fifth lens element comprise a plastic material or a glass material.

Preferably, a focal length of the first lens element is f1, a focal length of the second lens element is f2, and the following relationship is satisfied: 0.5 < (f/f1)+(f/f2) < 2.5.

Preferably, a focal length of the optical lens for capturing image is f, half of the maximal field of view of the optical lens for capturing image is HFOV, and the following relationship is satisfied: 1 < HFOV/f < 35.

Preferably, an Abbe number of the first lens element is V1, an Abbe number of the second lens element is V2, an Abbe number of the third lens element is V3, an Abbe number of the fourth lens element is V4, and the following relationship is satisfied: |V1-V4| < 10, |V2-V3|>28.

Based on purpose of the present invention, an image capture module is proposed. The image capture module comprises an optical lens for capturing image, an image sensing device, and an aperture stop. In order from an object side to an image side, the optical lens along the optical axis comprising: a first lens element along the optical axis with positive refractive power having a convex object-side surface; a second lens element along the optical axis with positive refractive power having a convex image-side surface; a third lens element along the optical axis with negative refractive power having a concave object-side surface and a convex image-side surface, wherein at least one of the object-side surface and the image-side surface of the third lens element is aspheric; a fourth lens element along the optical axis with refractive power having a convex object-side surface, both the object-side surface and the image-side surface of the fourth lens element are aspheric; and a fifth lens element along the optical axis with refractive power having a concave image-side surface and both the image-side surface and the object-side surface of the fifth lens element are aspheric, and at least one of the image-side surface and the object-side surface of the fifth lens element has at least one inflection point. The image sensing device is disposed on the image plane to capture the image of an object under shooting. The distance along the optical axis from the aperture stop to the image plane is SL, the distance along the optical axis from the object-side surface of the first lens element to the image plane is TTL, the distance along the optical axis from the object-side surface of the first lens element to the image-side surface of the fifth lens element is TD, the distance along the optical axis from the image-side surface of the fifth lens element to the image plane is BFL, and the following relationship is satisfied: 1.5 < TTL < 5.5, 1.5 < TD/BFL < 4.0, 0.5 < SL/TTL < 1.5.

Preferably, a focal length of the first lens element is f1, a focal length of the second lens element is f2, and the following relationship is satisfied: 0.5 < (f/f1)+(f/f2) < 2.5.

Preferably, a focal length of the optical lens for capturing image is f, half of the maximal field of view of the optical lens for capturing image is HFOV, and the following relationship is satisfied: 1 < HFOV/f < 35.

Preferably, an Abbe number of the first lens element is V1, an Abbe number of the second lens element is V2, an Abbe number of the third lens element is V3, an Abbe number of the fourth lens element is V4, and the following relationship is satisfied: |V1-V4| < 10, |V2-V3| > 28.

Preferably, the image capture module further comprises an IR-bandstop filter to adjust the wavelength limit of the light of the capturing image.

Preferably, the material of the IR-bandstop filter comprises a panel glass material, the image capture module makes the object be imaged on the image sensing device via the combination of the first lens element, the second lens element, the third lens element, the fourth lens element, the fifth lens element, the aperture stop, and the IR-bandstop filter.

**BRIEF DESCRIPTION OF THE DRAWINGS**

FIG. 1A is a schematic view of the image capture module according to a first embodiment of the present application.
FIG. 1B is astigmatic field curves and a distortion curve of the image capture module according to the first embodiment of the present application.
FIG. 1C is longitudinal spherical aberration curves of the image capture module according to the first embodiment of the present application.
FIG. 2A is a schematic view of the image capture module according to a second embodiment of the present application.
FIG. 2B is astigmatic field curves and a distortion curve of the image capture module according to the second embodiment of the present application.
FIG. 2C is longitudinal spherical aberration curves of the image capture module according to the second embodiment of the present application.
FIG. 3A is a schematic view of the image capture module according to a third embodiment of the present application.
FIG. 3B is astigmatic field curves and a distortion curve of the image capture module according to the third embodiment of the present application.
FIG. 3C is longitudinal spherical aberration curves of the image capture module according to the third embodiment of the present application.
FIG. 4A is a schematic view of the image capture module according to a fourth embodiment of the present application.

FIG. 4B is astigmatic field curves and a distortion curve of the image capture module according to the fourth embodiment of the present application.

FIG. 4C is longitudinal spherical aberration curves of the image capture module according to the fourth embodiment of the present application.

## DETAILED DESCRIPTION OF THE PREFERRED EMBODIMENTS

As used herein, the term "and/or" includes any and all combinations of one or more of the associated listed items. Expressions such as "at least one of," when preceding a list of elements, modify the entire list of elements and do not modify the individual elements of the list.

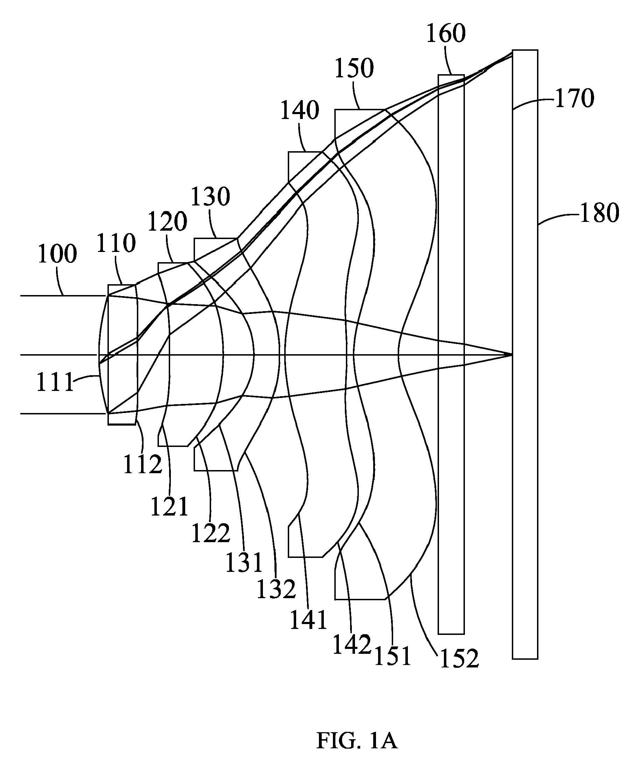

Referring to FIG. 1A, FIG. 1A is a schematic view of an image capture module according to a first embodiment of the present application. As shown in FIG. 1A, an image capture module of the present invention, sequentially arranged from an object side to an image side, along the optical axis comprising: the first lens element 110, the second lens element 120, the third lens element 130, the fourth lens element 140, and the fifth lens element 150. The first lens element 110 with positive refractive power has a convex object-side surface 111. The second lens element 120 with positive refractive power has a convex image-side surface 122. The third lens element 130 with negative refractive power has a concave object-side surface 131 and convex image-side surface 132, and at least one of an object-side surface 131 and the image-side surface 132 of the third lens element 130 is aspheric. The fourth lens element 140 with refractive power has a convex object-side surface 141, and both the object-side surface 141 and the image-side surface 142 of the fourth lens element 140 are aspheric. The fifth lens element 150 with refractive power having a concave image-side surface 152, and at least one of the object-side surface 151 and the image-side surface 152 of the fifth lens element 150 has at least one inflection point.

The image capture module of the present invention further comprises an aperture stop 100 and an IR-bandstop filter 160. The aperture stop 100 is a front aperture between a photographed object and the first lens element 110, and the IR-bandstop filter 160 is between the fifth lens element 150 and an image plane 170. The IR-bandstop filter 160 is generally made of panel glass without affecting the focal length of the image capture module.

The image capture module further comprises an image sensing device 180 on the image plane 170 for imaging an object to be imaged. The first lens element 110, the second lens element 120, the third lens element 130, the fourth lens element 140, and the fifth lens element 150 comprise a plastic material or a glass material, and the aspheric surface formula as given in Equation (1):

$$z=ch^2/[1+[1-(k+1)c^2h^2]^{0.5}]+Ah^4+Bh^6+Ch^8+Dh^{10}+Eh^{12}+Fh^{14}+Gh^{16}+Hh^{18}+Jh^{20} \qquad (1)$$

Wherein,

z is the position value of the position along the optical axis and at the height of h with reference to the surface apex,
k is the conic coefficient,
c is the reciprocal of curvature radius, and
A, B, C, D, E, F, G, H, and J are high level aspheric coefficient.

The detailed optical data of the first embodiment are show in Table 1, wherein the object-side surfaces and the image-side surfaces of the first lens element 110 to the fifth lens element 150 comply with the aspheric surface formula as given in Equation (1), their aspheric coefficients are listed in Table 2, f=3.02119mm, f1=4.231mm, f2=4.439mm, TTL=4.415mm, BFL=1.1226mm, SL=4.324mm, HFOV=44deg, and TD=3.189mm.

Table 1. The optical data of the first embodiment.

| The optical data of the first embodiment | | | | | | |
|---|---|---|---|---|---|---|
| Surface# | | Curvature Radius | Thickness | Index | Abbe#(V d) | Focal length |
| Aperture Stop | | ∞ | -0.09 | | | |
| Lens 1 | Surface #1 | 1.91 | 0.40 | 1.53 | 56.0 | 4.23 |
| | Surface #2 | 11.27 | 0.34 | | | |
| Lens 2 | Surface #3 | -7.69 | 0.56 | 1.53 | 56.0 | 4.44 |
| | Surface #4 | -1.86 | 0.33 | | | |

(continued)

| The optical data of the first embodiment | | | | | | |
|---|---|---|---|---|---|---|
| Surface# | | Curvature Radius | Thickness | Index | Abbe#(V d) | Focal length |
| Lens 3 | Surface #5 | -0.64 | 0.26 | 1.63 | 23.8 | -1.96 |
| | Surface #6 | -1.53 | 0.05 | | | |
| Lens 4 | Surface #7 | 1.76 | 0.66 | 1.54 | 56.0 | 2.370 |
| | Surface #8 | -4.19 | 0.07 | | | |
| Lens 5 | Surface #9 | 1.16 | 0.47 | 1.53 | 56.0 | -7.97 |
| | Surface #10 | 0.78 | 0.50 | | | |
| IR-bandstop filter | Surface #11 | ∞ | 0.3 | 1.51 | 64.1 | |
| | Surface #12 | ∞ | 0.42 | | | |

Table 2. The aspheric coefficients of the first embodiment.

| Surface # | 1 | 2 | 3 | 4 | 5 |
|---|---|---|---|---|---|
| k | -16.5 | 0.000 | 0.000 | -10.9 | -2.8 |
| A | 0.2473 | -0.0868 | -0.1029 | -0.1734 | -0.2655 |
| B | -0.5536 | -0.0759 | -0.0668 | -0.7516 | -0.1852 |
| C | 1.2251 | -0.2242 | -1.2545 | 3.2816 | 0.1347 |
| D | -3.4732 | 1.0533 | 6.3316 | -8.878 | 0.7980 |
| E | 6.9524 | -2.6951 | -13.8915 | 14.5750 | 0.4635 |
| F | -8.1183 | 2.9995 | 14.5881 | -12.6233 | -2.5953 |
| G | 3.9631 | -0.9737 | -5.6691 | 4.3645 | 1.4673 |
| Surface # | 6 | 7 | 8 | 9 | 10 |
| k | -1.57 | -0.55 | -22.8 | -6.6 | -4.0 |
| A | -0.0824 | -0.1760 | 0.2828 | -0.0558 | -0.0655 |
| B | -0.0685 | 0.1649 | -0.1953 | -0.0414 | 0.0027 |
| C | -0.2262 | -0.1464 | 0.0613 | 0.0500 | 0.0078 |
| D | 1.1256 | 0.0727 | -0.0081 | -0.0235 | -0.0039 |
| E | -1.3107 | -0.0198 | -0.0006 | 0.0054 | 0.0008 |
| F | 0.6302 | 0.0025 | -0.0006 | -0.0006 | -0.0001 |
| G | -0.1099 | -9.5e-005 | -2.2e-005 | -0.0006 | 4.4e-006 |

In the embodiment of the present image capture module, each related equation is expressed as below: TTL=4.415mm, HFOV/f = 14.564, TD/BFL = 2.601, (f/f1)+(f/f2) = 1.395, SL/TTL = 0.979, |V1-V4| = 0.02, and |V2-V3| = 32.18.

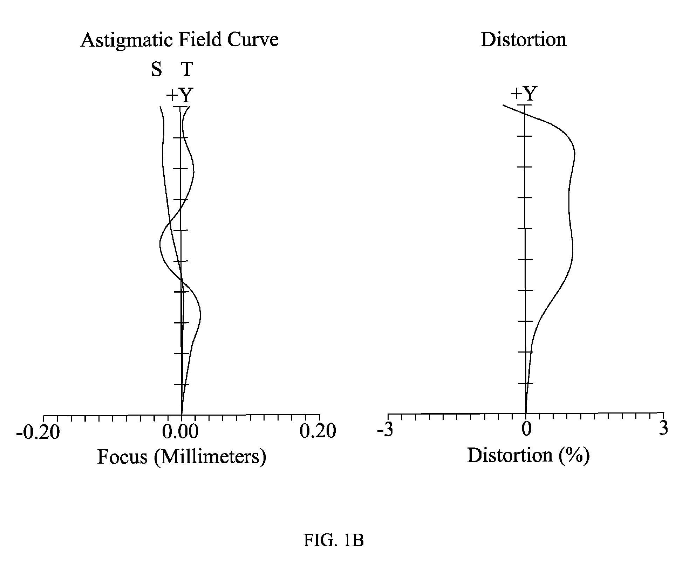

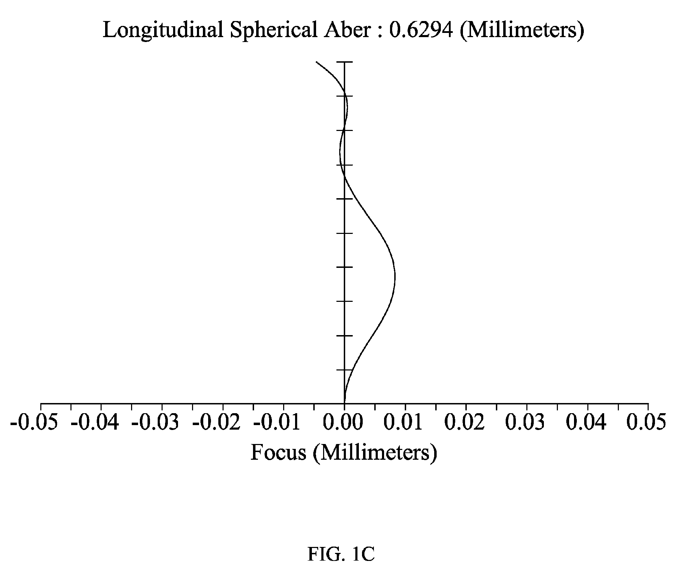

According to the optical data as shown in Table 1 and the series of aberration curves as shown in FIG. 1B and FIG. 1C, the image capture module in accordance with this preferred embodiment of the present invention provides good correction results in aspects of the longitudinal spherical aberration, astigmatic field curving, and distortion.

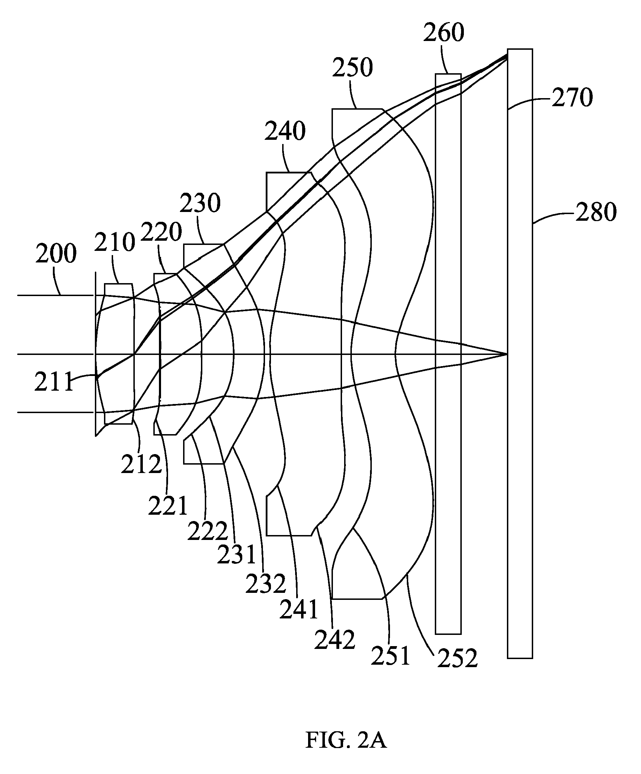

Referring to FIG. 2A, FIG. 2A is a schematic view of the image capture module according to a second embodiment of the present application. As shown in FIG. 2A, an image capture module of the present invention, sequentially arranged from an object side to an image side, along the optical axis comprising: the first lens element 210, the second lens element 220, the third lens element 230, the fourth lens element 240, and the fifth lens element 250. The first lens element 210 with positive refractive power has a convex object-side surface 211. The second lens element 220 with positive refractive power has a convex image-side surface 222. The third lens element 230 with negative refractive power has a concave object-side surface 231 and a convex image-side surface 232, and at least one of the object-side surface 231 and the image-side surface 232 of the third lens element 230 is aspheric. The fourth lens element 240 with refractive power has a convex object-side surface 241, and both the object-side surface 241 and the image-side surface 242 of the fourth lens element 240 are aspheric. The fifth lens element 250 with refractive power having a concave image-side surface 252, and at least one of the object-side surface 251 and the image-side surface 252 of the fifth lens element 250 has at least one inflection point.

The image capture module of the present invention further comprises an aperture stop 200 and an IR-bandstop filter 260. The aperture stop 200 is a middle aperture between a photographed object and the second lens element 220, and the IR-bandstop filter 260 is between the fifth lens element 250 and an image plane 270. The IR-bandstop filter 260 is generally made of panel glass without affecting the focal length of the image capture module.

The image capture module further comprises an image sensing device 280 on the image plane 270 for imaging an object to be imaged. The first lens element 210, the second lens element 220, the third lens element 230, the fourth lens element 240, and the fifth lens element 250 comprise a plastic material or a glass material.

The detailed optical data of the second embodiment are show in Table 3, wherein the object-side surfaces and the image-side surfaces of the first lens element 210 to the fifth lens element 250 comply with the aspheric surface formula as given in Equation (1), their aspheric coefficients are listed in Table 4, f=1.7434mm, f1=3.012mm, f2=2.358mm, TTL=2.579mm, BFL=0.692mm, SL=2.348mm, HFOV=44deg, and TD=1.887mm.

Table 3. The optical data of the second embodiment.

| The optical data of the second embodiment | | | | | | |
|---|---|---|---|---|---|---|
| Surface# | | Curvature Radius | Thickness | Index | Abbe#(V d) | Focal length |
| Lens 1 | Surface #1 | 1.15 | 0.22 | 1.53 | 56.0 | 3.01 |
| | Surface #2 | 3.76 | 0.00 | | | |
| Aperture Stop | | ∞ | 0.16 | | | |
| Lens 2 | Surface #3 | 5.76 | 0.26 | 1.53 | 56.0 | 2.35 |
| | Surface #4 | -1.59 | 0.20 | | | |
| Lens 3 | Surface #5 | -0.39 | 0.19 | 1.63 | 23.9 | -1.26 |
| | Surface #6 | -0.93 | 0.03 | | | |
| Lens 4 | Surface #7 | 1.05 | 0.45 | 1.54 | 56.0 | 1.61 |
| | Surface #8 | -4.63 | 0.09 | | | |
| Lens 5 | Surface #9 | 0.66 | 0.25 | 1.53 | 56.0 | -9.63 |
| | Surface #10 | 0.50 | 0.2 | | | |
| IR-bandstop filter | Surface #11 | ∞ | 0.14 | 1.51 | 64.2 | |
| | Surface #12 | ∞ | 0.29 | | | |

Table 4. The aspheric coefficients of the second embodiment

| Surface # | 1 | 2 | 3 | 4 | 5 |
|---|---|---|---|---|---|
| k | -12.8 | 0.00 | 0.00 | -2.55 | -2.58 |
| A | 0.8162 | -0.8575 | -0.9379 | -0.6746 | -2.1663 |
| B | -8.7701 | -0.7109 | -1.4445 | -12.590 | -1.5984 |
| C | 72.7 | -32.0 | -39.9 | 138.5 | 10.379 |
| D | -602 | 191 | 574 | -1264 | 120 |
| E | 2676 | -339 | -6177 | 6397 | 217 |
| F | -6110 | -1183 | 31673 | -15339 | -3336 |

(continued)

| Surface # | 1 | 2 | 3 | 4 | 5 |
|---|---|---|---|---|---|
| G | 5053 | 5231 | -53644 | 14611 | 5112 |
| Surface # | 6 | 7 | 8 | 9 | 10 |
| k | -0.90 | 0.30 | 15.12 | -4.15 | -3.17 |
| A | -0.8214 | -1.1201 | 1.0972 | -0.3710 | -0.4448 |
| B | 0.4115 | 2.1925 | -2.6353 | -0.6217 | 0.1350 |
| C | -9.9564 | -6.2397 | 2.77159 | 2.3546 | 0.3494 |
| D | 156 | 10.0 | -1.2465 | -3.3321 | -0.5699 |
| E | -561 | -9.1454 | -0.2730 | 2.3225 | 0.3827 |
| F | 803 | 3.4159 | 0.39666 | -0.7804 | -0.1260 |
| G | -408 | -0.5063 | -0.0587 | 0.1013 | 0.0164 |

In the embodiment of the present image capture module, each related equation is expressed as below: TTL=2.579mm, HFOV/f= 25.238, TD/BFL = 2.726, (f/f1)+(f/f2) = 1.318, SL/TTL = 0.911, |V1-V4| = 0.02, and |V2-V3| = 32.18.

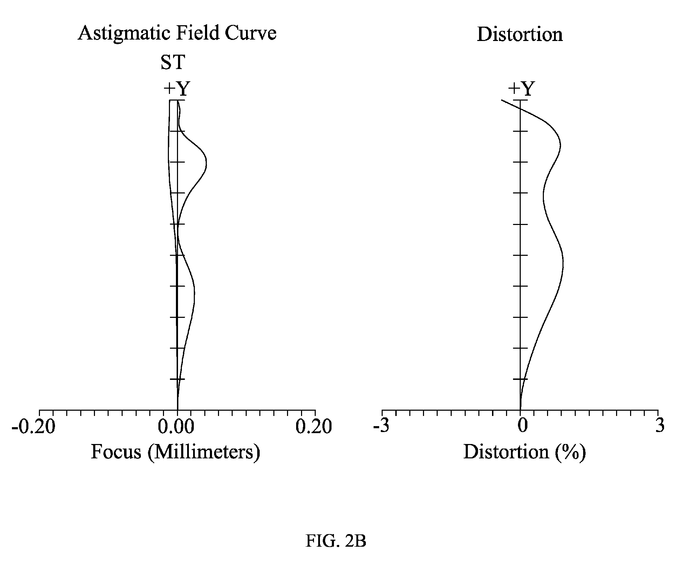

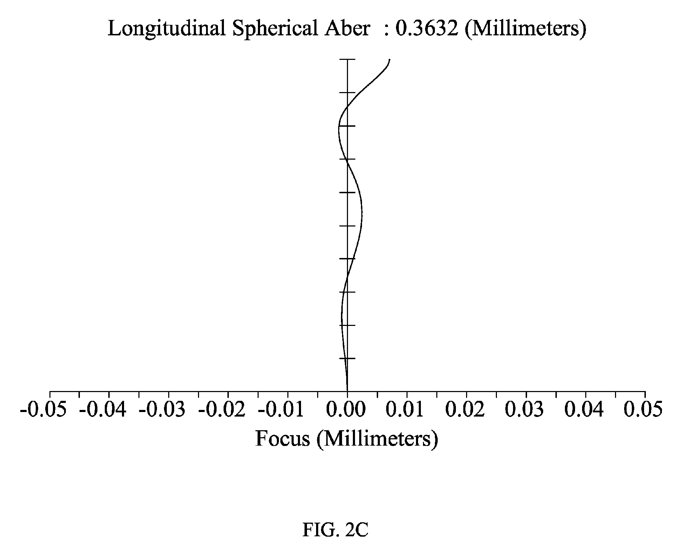

According to the optical data as shown in Table 3 and the series of aberration curves as shown in FIG. 2B and FIG. 2C, the image capture module in accordance with this preferred embodiment of the present invention provides good correction results in aspects of the longitudinal spherical aberration, astigmatic field curving, and distortion.

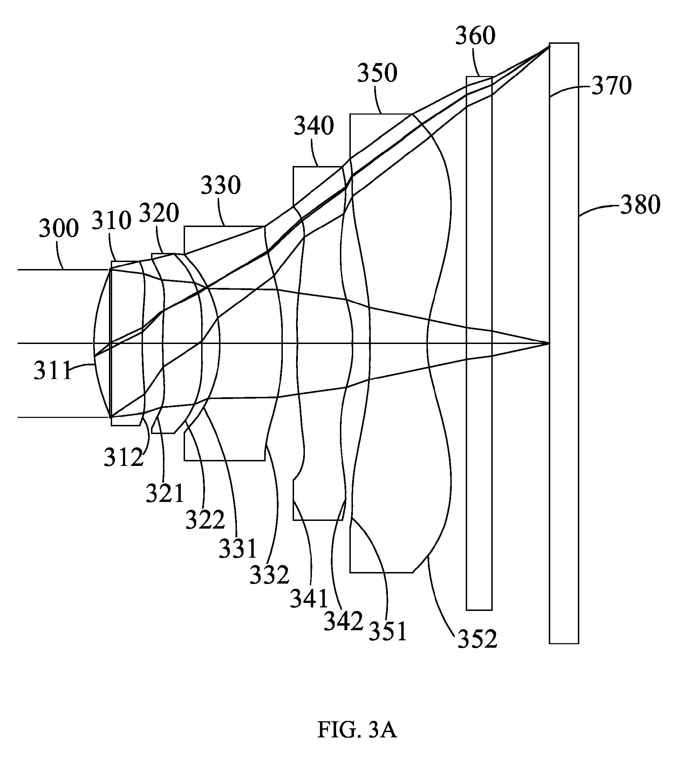

Referring to FIG. 3A, FIG. 3A is a schematic view of the image capture module according to a third embodiment of the present application. As shown in FIG. 3A, an image capture module of the present invention, sequentially arranged from an object side to an image side, along the optical axis comprising: the first lens element 310, the second lens element 320, the third lens element 330, the fourth lens element 340, and the fifth lens element 350. The first lens element 310 with positive refractive power has a convex object-side surface 311. The second lens element 320 with positive refractive power has a convex image-side surface 322. The third lens element 330 with negative refractive power has a concave object-side surface 331 and a convex image-side surface 332, and at least one of the object-side surface 331 and the image-side surface 332 of the third lens element 330 is aspheric. The fourth lens element 340 with refractive power has a convex object-side surface 341, and both the object-side surface 341 and the image-side surface 342 of the fourth lens element 340 are aspheric. The fifth lens element 350 with refractive power having a concave image-side surface 352, and at least one of the object-side surface 351 and the image-side surface 352 of the fifth lens element 350 has at least one inflection point.

The image capture module of the present invention further comprises an aperture stop 300 and an IR-bandstop filter 360. The aperture stop 300 is a front aperture between a photographed object and the first lens element 310, and the IR-bandstop filter 360 is between the fifth lens element 350 and an image plane 370. The IR-bandstop filter 360 is generally made of panel glass without affecting the focal length of the image capture module.

The image capture module further comprises an image sensing device 380 on the image plane 370 for imaging an object to be imaged. The first lens element 310, the second lens element 320, the third lens element 330, the fourth lens element 340, and the fifth lens element 350 comprise a plastic material or a glass material.

The detailed optical data of the third embodiment are show in Table 5, wherein the object-side surfaces and the image-side surfaces of the first lens element 310 to the fifth lens element 350 comply with the aspheric surface formula as given in Equation (1), their aspheric coefficients are listed in Table 6, f=3.291mm, f1=3.97mm, f2=5.065mm, TTL=4.248mm, BFL=1.132mm, SL=4.102mm, HFOV=37.5deg, and TD=3.116mm.

Table 5. The optical data of the third embodiment.

| The optical data of the third embodiment. | | Curvature Radius | Thickness | Index | Abbe#(V d) | Focal length |
|---|---|---|---|---|---|---|
| Surface# | | Curvature Radius | Thickness | Index | Abbe#(V d) | Focal length |
| Aperture Stop | | ∞ | -0.14 | | | |
| Lens 1 | Surface #1 | 1.48 | 0.45 | 1.54 | 56.1 | 3.98 |
| | Surface #2 | 4.3 | 0.2 | | | |

(continued)

| The optical data of the third embodiment. | | | | | | |
|---|---|---|---|---|---|---|
| Surface# | | Curvature Radius | Thickness | Index | Abbe#(V d) | Focal length |
| Lens 2 | Surface #3 | 5.81 | 0.37 | 1.54 | 56.1 | 5.06 |
| | Surface #4 | -5.2 | 0.16 | | | |
| Lens 3 | Surface #5 | -1.36 | 0.58 | 1.64 | 23.9 | -3.47 |
| | Surface #6 | -4.06 | 0.14 | | | |
| Lens 4 | Surface #7 | 5.56 | 0.53 | 1.54 | 56.1 | 1.77 |
| | Surface #8 | -1.13 | 0.16 | | | |
| Lens 5 | Surface #9 | -3.9 | 0.54 | 1.54 | 56.1 | -1.57 |
| | Surface #10 | 1.12 | 0.35 | | | |
| IR-bandstop filter | Surface #11 | ∞ | 0.2 | 1.52 | 64.2 | |
| | Surface #12 | ∞ | 0.57 | | | |

Table 6. The aspheric coefficients of the third embodiment

| Surface # | 1 | 2 | 3 | 4 | 5 |
|---|---|---|---|---|---|
| k | -14.36 | 0.00 | 0.00 | 0.00 | -3.42 |
| A | 0.5464 | -0.0567 | -0.206 | -0.316 | -0.4172 |
| B | -1.610 | -0.7421 | 0.1601 | -0.2606 | 0.129 |
| C | 5.187 | 3.588 | -5.32 | -0.0195 | -0.554 |
| D | -14.031 | -14.820 | 25.31 | -3.266 | 2.493 |
| E | 24.700 | 32.534 | -70.401 | 15.125 | 0.780 |
| F | -25.059 | -39.088 | 95.776 | -21.803 | -7.015 |
| G | 10.384 | 20.536 | -46.993 | 10.6934 | 4.031 |
| Surface # | 6 | 7 | 8 | 9 | 10 |
| k | -154.9 | -244 | -0.93 | 0.405 | -7.138 |
| A | -0.492 | 0.099 | 0.557 | 0.053 | -0.11157 |
| B | 1.026 | -0.128 | -0.2545 | -0.116 | 0.075 |
| C | -2.295 | 0.07 | 0.033 | 0.1452 | -0.0428 |
| D | 4.186 | 0.01 | 0.0064 | -0.085 | 0.016 |
| E | -4.245 | -0.07 | 0.0004 | 0.027 | -0.004 |
| F | 2.150 | 0.045 | -0.001 | -0.0046 | 0.0005 |
| G | -0.4287 | -0.010 | 0.0001 | 0.0003 | -3.094e-005 |

In the embodiment of the present image capture module, each related equation is expressed as below: TTL=4.248mm, HFOV/f = 11.393, TD/BFL = 2.752, (f/f1)+(f/f2) = 1.477, SL/TTL = 0.966, |V1-V4| = 0.02, and |V2-V3| = 32.18.

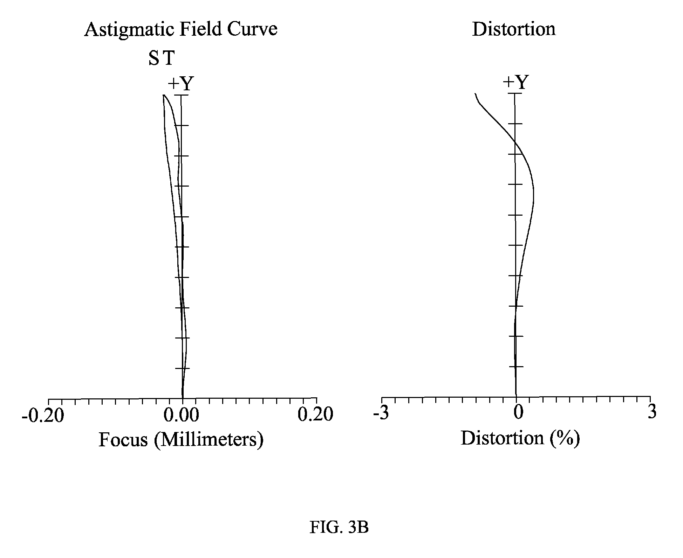

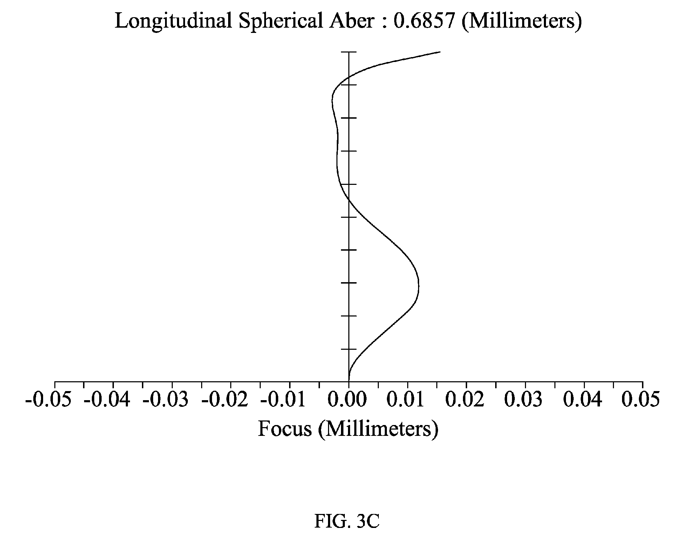

According to the optical data as shown in Table 5 and the series of aberration curves as shown in FIG. 3B and FIG. 3C, the image capture module in accordance with this preferred embodiment of the present invention provides good correction results in aspects of the longitudinal spherical aberration, astigmatic field curving, and distortion.

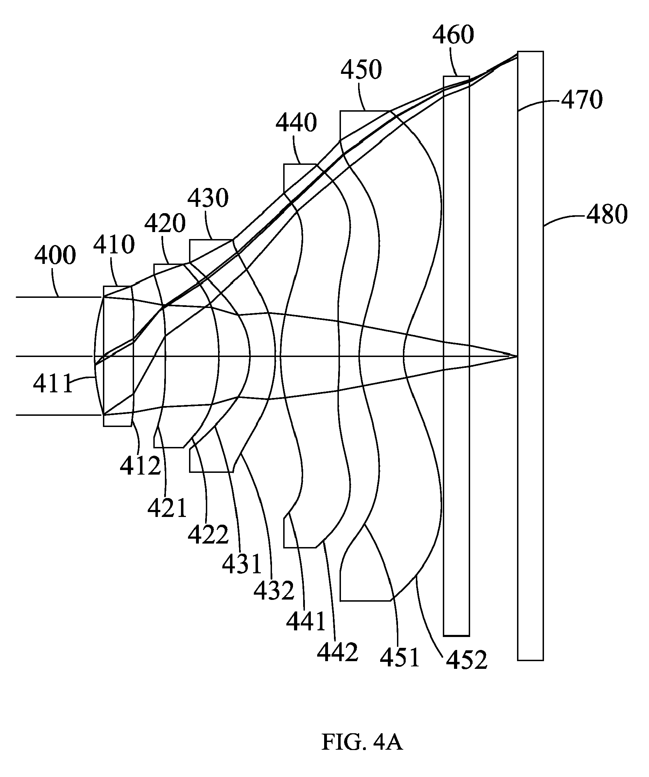

Referring to FIG. 4A, FIG. 4A is a schematic view of the image capture module according to a fourth embodiment of the present application. As shown in FIG. 4A, an image capture module of the present invention, sequentially arranged from an object side to an image side, along the optical axis comprising: the first lens element 410, the second lens element 420, the third lens element 430, the fourth lens element 440, the fifth lens element 450. The first lens element 410 with positive refractive power has a convex object-side surface 411. The second lens element 420 with positive refractive power has a convex image-side surface 422. The third lens element 430 with negative refractive power has a concave object-side surface 431 and a convex image-side surface 432, and at least one of the object-side surface 431 and the image-side surface 432 of the third lens element 430 is aspheric. The fourth lens element 440 with refractive power has a convex object-side surface 441, and both the object-side surface 441 and the image-side surface 442 of the fourth lens element 440 are aspheric. The fifth lens element 450 with refractive power having a concave image-side surface 452, and at least one of the object-side surface 451 and the image-side surface 452 of the fifth lens element 450 has at least one inflection point.

The image capture module of the present invention further comprises an aperture stop 400 and an IR-bandstop filter 460. The aperture stop 400 is a front aperture between a photographed object and the first lens element 410, and the IR-bandstop filter 460 is between the fifth lens element 450 and an image plane 470. The IR-bandstop filter 460 is generally made of panel glass without affecting the focal length of the image capture module.

The image capture module further comprises an image sensing device 480 on the image plane 470 for imaging an object to be imaged. The first lens element 410, the second lens element 420, the third lens element 430, the fourth lens element 440, and the fifth lens element 450 comprise a plastic material or a glass material.

The detailed optical data of the fourth embodiment are show in Table 7, wherein the object-side surfaces and the image-side surfaces of the first lens element 410 to the fifth lens element 450 comply with the aspheric surface formula as given in Equation (1), their aspheric coefficients are listed in Table 8, f=2.333mm, f1=3.329mm, f2=3.716mm, TTL=3.413mm, BFL=0.964mm, SL=3.338mm, HFOV=44deg, and TD=2.449mm.

Table 7. The optical data of the fourth embodiment.

| The optical data of the fourth embodiment | | | | | | |
|---|---|---|---|---|---|---|
| Surface# | | Curvature Radius | Thickness | Index | Abbe#(V d) | Focal length |
| Aperture Stop | | ∞ | -0.07 | | | |
| Lens 1 | Surface #1 | 1.39 | 0.33 | 1.53 | 56.0 | 3.32 |
| | Surface #2 | 5.78 | 0.20 | | | |
| Lens 2 | Surface #3 | -8.10 | 0.37 | 1.53 | 56.0 | 3.71 |
| | Surface #4 | -1.62 | 0.22 | | | |
| Lens 3 | Surface #5 | -0.49 | 0.23 | 1.63 | 23.8 | -1.96 |
| | Surface #6 | -0.96 | 0.04 | | | |
| Lens 4 | Surface #7 | 1.45 | 0.44 | 1.53 | 56.0 | 3.71 |
| | Surface #8 | 4.83 | 0.16 | | | |
| Lens 5 | Surface #9 | 0.82 | 0.42 | 1.53 | 56.0 | 9.74 |
| | Surface #10 | 0.79 | 0.3 | | | |
| IR-bandstop filter | Surface #11 | ∞ | 0.21 | 1.51 | 64.1 | |
| | Surface #12 | ∞ | 0.42 | | | |

Table 8. The aspheric coefficients of the fourth embodiment

| Surface # | 1 | 2 | 3 | 4 | 5 |
|---|---|---|---|---|---|
| k | -19.91 | 0.00 | 0.00 | 3.61 | -2.26 |
| A | 0.8325 | -0.2545 | -0.3301 | -0.2036 | -0.8916 |
| B | -3.6325 | -0.1298 | -1.2406 | -2.2349 | 0.4043 |
| C | 12.47 | -4.558 | -1.7129 | 15.75 | -1.5038 |
| D | -33.52 | 16.48 | 31.81 | -93.60 | 14.45 |

(continued)

| Surface # | 1 | 2 | 3 | 4 | 5 |
|---|---|---|---|---|---|
| E | 44.78 | -36.9 | -227.3 | 300.1 | 6.0 |
| F | -17.741 | 23.90 | 632.4 | -448.68 | -94.8 |
| G | -25.1 | 36.95 | -562.1 | 255.3 | 91.2 |
| Surface # | 6 | 7 | 8 | 9 | 10 |
| k | -1.2 | 0.29 | 0.00 | -4.92 | -3.50 |
| A | -0.3595 | -0.5169 | 0.0457 | -0.0814 | -0.1265 |
| B | 0.4388 | 0.6485 | -0.1406 | -0.2100 | -0.017 |
| C | -0.7770 | -0.8597 | 0.0789 | 0.3405 | 0.0740 |
| D | 9.8957 | 0.6976 | -0.0228 | -0.2523 | -0.0508 |
| E | -24.35 | -0.3809 | -0.0004 | 0.0973 | 0.0162 |
| F | 22.81 | 0.1291 | 0.0014 | -0.0187 | -0.0026 |
| G | -7.4 | -0.0250 | -0.0001 | 0.0014 | 0.0001 |

In the embodiment of the present image capture module, each related equation is expressed as below: TTL=3.413mm, HFOV/f = 18.856, TD/BFL = 2.541, (f/f1)+(f/f2) = 1.329, SL/TTL = 0.978, |V1-V4| = 0.00, and |V2-V3| = 32.18.

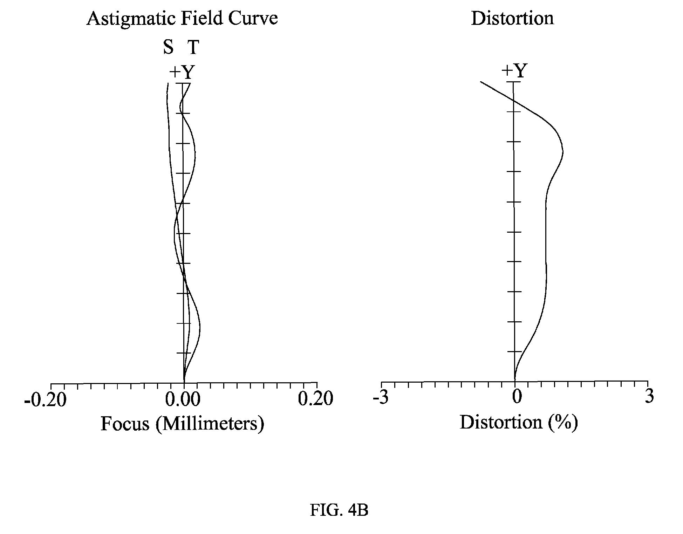

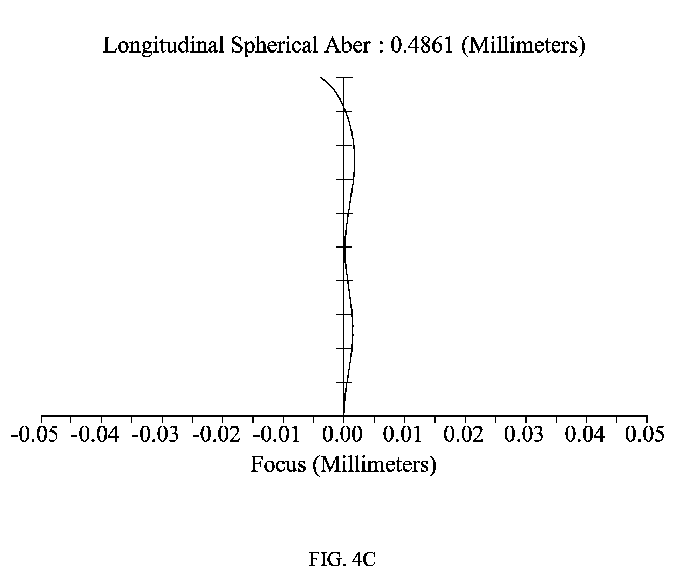

According to the optical data as shown in Table 7 and the series of aberration curves as shown in FIG. 4B and FIG. 4C, the image capture module in accordance with this preferred embodiment of the present invention provides good correction results in aspects of the longitudinal spherical aberration, astigmatic field curving, and distortion.

In the optical lens for capturing image of the present invention, the lens elements can be made of glass or plastic material. If the lens elements are made of glass, the freedom for distributing the refractive power of the optical lens for capturing image can be increased. If plastic material is adopted to produce the lens elements, the production cost will be reduced effectively.

In the optical lens for capturing image of the present invention, if the lens element has a convex surface, then the surface of the lens element is convex at a position in proximity to the optical axis; and if the lens element has a concave surface, then the surface of the lens element is concave at a position in proximity to the optical axis.

In the image capture module of the present invention, the aperture stop can be a front or middle aperture. If the aperture stop is a front aperture, a longer distance between the exit pupil of the image capture module and the image plane can be achieved to provide the telecentric effect and improve the image receiving efficiency of the image sensor such as the CCD or CMOS. If the aperture stop is a middle aperture, the view angle of the system can be expanded to provide a wide angle lens of the image capture module.

The aforementioned preferred embodiment is to explain the technical ideas and features of the present application. The purpose is to enable those who skilled in this technical area to understand the content of the present application and realize it. It will be understood that the present application is not limited to the details thereof. Various equivalent variations and modifications may still occur to those skilled in this art in view of the teachings of the present application. Thus, all such variations and equivalent modifications are also embraced with the scope of the present application as defined in the appended claim.

**Claims**

1.   An optical lens for capturing image, in order from an object side to an image side, the optical lens along the optical axis comprising :

a first lens element (110) along the optical axis with positive refractive power, having a convex object-side surface (111);
a second lens element (120) along the optical axis with positive refractive power, having a convex image-side surface (122);
a third lens element (130) along the optical axis with negative refractive power, having a convex image-side surface (132) and a concave object-side surface (131), wherein at least one of the object-side surface (131) and the image-side surface (132) of the third lens element (130) is aspheric;

a fourth lens element (140) along the optical axis with refractive power, having a convex object-side surface (141), both the object-side surface (141) and the image-side surface (142) of the fourth lens element (140) are aspheric; and

a fifth lens element (150) along the optical axis with refractive power, having a concave image-side surface (152) and both the image-side surface (152) and the object-side surface (151) are aspheric, and at least one of the image-side surface (152) and object-side surface (151) has at least one inflection point.

2. The optical lens for capturing image of claim 1, wherein the material of the first lens element (110), the second lens element (120), the third lens element (130), the fourth lens element (140), and the fifth lens element (150) comprise a plastic material or a glass material.

3. The optical lens for capturing image of claim 1, wherein a focal length of the first lens element (110) is f1, a focal length of the second lens element (120) is f2, and the following relationship is satisfied: 0.5 < (f/f1)+(f/f2) < 2.5.

4. The optical lens for capturing image of claim 3, wherein a focal length of the optical lens for capturing image is f, half of the maximal field of view of the optical lens for capturing image is HFOV, and the following relationship is satisfied: 1 < HFOV/f < 35.

5. The optical lens for capturing image of claim 1, wherein an Abbe number of the first lens element (110) is V1, an Abbe number of the second lens element (120) is V2, an Abbe number of the third lens element (130) is V3, an Abbe number of the fourth lens element (140) is V4, and the following relationship is satisfied: |V1-V4| < 10, |V2-V3| > 28.

6. An image capture module, comprising:

   an optical lens for capturing image, in order from an object side to an image side, the optical lens along the optical axis comprising:

   a first lens element (110) along the optical axis with positive refractive power, having a convex object-side surface (111);
   a second lens element (120) along the optical axis with positive refractive power, having a convex image-side surface (122);
   a third lens element (130) along the optical axis with negative refractive power, having a convex image-side surface (132) and a concave object-side surface (131), wherein at least one of the object-side surface (131) and the image-side surface (132) of the third lens element (130) is aspheric;
   a fourth lens element (140) along the optical axis with refractive power, having a convex object-side surface (141), both the object-side surface (141) and the image-side surface (142) of the fourth lens element (140) are aspheric; and
   a fifth lens element (150) along the optical axis with refractive power having a concave image-side surface (142) and both the image-side surface (142) and the object-side surface (141) are aspheric, and at least one of the image-side surface (142) and object-side surface (141) has at least one inflection point;
   an image sensing device (180), disposed on the image plane (170) for image formation for an object; and
   an aperture stop (100);
   wherein the distance along the optical axis from the aperture stop (100) to the image plane (170) is SL, the distance along the optical axis from the object-side surface (111) of the first lens element (110) to the image plane (170) is TTL, the distance along the optical axis from the object-side surface (111) of the first lens element (110) to the image-side surface (152) of the fifth lens element (150) is TD, the distance along the optical axis from the image-side surface (152) of the fifth lens element (150) to the image plane (170) is BFL, and the following relationship is satisfied: 1.5 < TTL < 5.5, 1.5 < TD/BFL < 4.0, 0.5 < SL/TTL < 1.5.

7. The image capture module of claim 6, wherein a focal length of the first lens element (110) is f1, a focal length of the second lens element (120) is f2, and the following relationship is satisfied: 0.5 < (f/f1)+(f/f2) < 2.5.

8. The image capture module of claim 6, wherein a focal length of the optical lens for capturing image is f, half of the maximal field of view of the optical lens for capturing image is HFOV, and the following relationship is satisfied: 1 < HFOV/f < 35.

**9.** The image capture module of claim 6, wherein an Abbe number of the first lens element (110) is V1, an Abbe number of the second lens element (120) is V2, an Abbe number of the third lens element (130) is V3, an Abbe number of the fourth lens element (140) is V4, and the following relationship is satisfied: $|V1-V4| < 10$, $|V2-V3| > 28$.

**10.** The image capture module of claim 6, further comprising an IR-bandstop filter (160) to adjust the wavelength limit of the light for image formation.

**11.** The image capture module of claim 10, wherein the material of the IR-bandstop filter (160) comprises a panel glass material, the image capture module makes the object be imaged on the image sensing device (180) via the combination of the first lens element (110), the second lens element (120), the third lens element (130), the fourth lens element (140), the fifth lens element (150), the aperture stop (100), and the IR-bandstop filter (160).

FIG. 1A

Astigmatic Field Curve

S   T

+Y

-0.20          0.00          0.20

Focus (Millimeters)

Distortion

+Y

-3          0          3

Distortion (%)

FIG. 1B

Longitudinal Spherical Aber : 0.6294 (Millimeters)

-0.05  -0.04  -0.03  -0.02  -0.01   0.00   0.01   0.02   0.03   0.04   0.05

Focus (Millimeters)

FIG. 1C

FIG. 2A

Astigmatic Field Curve
ST

Distortion

FIG. 2B

Longitudinal Spherical Aber : 0.3632 (Millimeters)

Focus (Millimeters)

FIG. 2C

FIG. 3A

Astigmatic Field Curve
S T

Distortion

Focus (Millimeters)

Distortion (%)

FIG. 3B

Longitudinal Spherical Aber : 0.6857 (Millimeters)

Focus (Millimeters)

FIG. 3C

FIG. 4A

Astigmatic Field Curve

S  T

+Y

Distortion

+Y

-0.20          0.00          0.20

Focus (Millimeters)

-3          0          3

Distortion (%)

FIG. 4B

Longitudinal Spherical Aber : 0.4861 (Millimeters)

-0.05  -0.04  -0.03  -0.02  -0.01  0.00  0.01  0.02  0.03  0.04  0.05

Focus (Millimeters)

FIG. 4C

**EP 2 860 565 A1**

Europäisches
Patentamt

European
Patent Office

Office européen
des brevets

## EUROPEAN SEARCH REPORT

Application Number

EP 14 16 0437

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TW 201 335 619 A (CHEN W) 1 September 2013 (2013-09-01) * see family member US2014/340766 provided as a translation * & US 2014/340766 A1 (HSU PO-LUN [TW] ET AL) 20 November 2014 (2014-11-20) * figure 3; tables 5,6 * * paragraph [0047] * * paragraph [0092] * | 1-11 | INV. G02B13/00 G02B13/18 G02B3/04 G02B9/60 |
| X | JP 2009 294528 A (FUJINON CORP) 17 December 2009 (2009-12-17) * figure 5; tables 15,25 * * paragraph [0001] * | 1-4,6 | |
| A | WARREN J SMITH ED - WARREN J SMITH: "Excerpt. Scaling a Design, Its Aberrations, and Its MTF", 1 January 1992 (1992-01-01), OPTICAL AND ELECTRO-OPTICAL ENGINEERING SERIES(OPTICS TOOLBOX); [OPTICAL AND ELECTRO-OPTICAL ENGINEERING SERIES], MC GRAW-HILL, NEW YORK, PAGE(S) 57 - 58, XP007908443, ISBN: 978-0-07-059178-3 * the whole document * | 6 | |

TECHNICAL FIELDS
SEARCHED (IPC)

G02B

The present search report has been drawn up for all claims

| Place of search | Date of completion of the search | Examiner |
|---|---|---|
| Munich | 5 December 2014 | Linke, Felix |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 16 0437

This annex lists the patent family members relating to the patent documents cited in  the above-mentioned European search report.
The members are as contained in the European Patent Office EDP file on
The European Patent Office is in no way liable for these particulars which are merely given for the purpose of information.

05-12-2014

| Patent document cited in search report | Publication date | Patent family member(s) | | Publication date |
|---|---|---|---|---|
| TW 201335619 A | 01-09-2013 | CN | 104166222 A | 26-11-2014 |
| | | TW | 201335619 A | 01-09-2013 |
| | | US | 2014340766 A1 | 20-11-2014 |
| JP 2009294528 A | 17-12-2009 | CN | 201378216 Y | 06-01-2010 |
| | | JP | 5073590 B2 | 14-11-2012 |
| | | JP | 2009294528 A | 17-12-2009 |
| | | TW | M370083 U | 01-12-2009 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- TW 102136420